Europäisches Patentamt

European Patent Office

Office européen des brevets

(19)

(11) Publication number: **0 008 782**
B1

(12) **EUROPEAN PATENT SPECIFICATION**

(45) Date of publication of patent specification: **17.03.82**

(21) Application number: **79103224.6**

(22) Date of filing: **31.08.79**

(51) Int. Cl.³: **C 04 B 41/14, H 01 B 1/16, H 01 J 9/02, H 01 J 9/26**

(54) **Process for providing overglaze for fired metallizations and AC plasma display panel comprising two overglazed substrates.**

(30) Priority: **01.09.78 US 938803**

(43) Date of publication of application:
**19.03.80 Bulletin 80/6**

(45) Publication of the grant of the patent:
**17.03.82 Bulletin 82/11**

(84) Designated Contracting States:
**DE FR GB**

(56) References cited:
**DE - A - 2 142 646**
**US - A - 3 450 545**
**US - A - 3 778 127**

(73) Proprietor: **E.I. DU PONT DE NEMOURS AND COMPANY**
**Legal Department 1007 Market Street**
**Wilmington Delaware 19898 (US)**

(72) Inventor: **Jolley, John Eric**
**20 Boulderbrook Drive**
**Boulderbrook Wilmington, Del. 19803 (US)**

(74) Representative: **Abitz, Walter, Dr.-Ing. et al,**
**Abitz, Morf, Gritschneder P.O. Box 86 01 09**
**D-8000 München 86 (DE)**

Courier Press, Leamington Spa, England.

Process for providing overglaze for fired metallizations and AC plasma display panel
comprising two overglazed substrates

## Background Art

Noble metal metallizing compositions are well known in the art.

U.S. 3,450,545, issued June 17, 1969 to K. H. Ballard, et al. discloses compositions containing noble metals, an inorganic binder, an oxide precursor additive selected from rhodium, iridium, ruthenium, copper, silicon carbide and boron nitride, and a vehicle. The additive is said to increase the joint strengths of the metallizings and the resistance to fissuring during firing of the compositions.

Direct screen printing of thick film electrodes is described in, *e.g.,* J. J. Hoehn, SID, International Symposium Digest, 1977, pages 18—19. Their utilization for AC plasma display panels necessitates the use of a dielectric overglaze over the electrodes. The statement is made, however, that materials such as silver are destroyed by the high temperature required for curing the overglaze.

There exists a need for screen printable thick film compositions useful in forming electrodes for AC plasma display panels which can be printed with high resolution and which can withstand high temperatures for the long time periods necessary for firing the dielectric overglaze.

## Disclosure of the Invention

The thick film silver conductor compositions used in the process of this invention can provide fine line electrodes; the fired metallizations are resistant to fissuring during subsequent overglazing. The compositions consists essentially of:

(A) 50—85% by weight, based on the weight of the composition, of silver particles having a particle size range of 0.05—20 micrometers;

(B) 1—10% by weight, based on the weight of the composition, of inorganic non-glass forming refractory materials or their precursors, such as aluminum oxide, cadmium oxide, gadolinium oxide, zirconium oxide, cobalt/iron/chromium oxide and aluminum, having a particle size range of 0.05—44 micrometers with at least 80% by weight of the particles in the 0.1—5 micrometer range;

(C) 5—20% by weight, based on the weight of the composition, of glass frit having a softening point range of 325—600°C such as lead borosilicate-based glass; and

(D) 10—30% by weight, based on the weight of the composition, of vehicle such as a UV polymerizable solution of polymethyl methacrylate and a polyfunctional monomer or a non-UV polymerizable solution of ethyl cellulose.

The process of the invention for providing an overglaze for fired metallizations comprises the steps of:

(A) printing and drying or drying and curing onto a substrate the above silver composition;

(B) firing the product from step (A); and

(C) applying an overglaze composition over the fired metallization and firing at a temperature and for a time sufficient to produce a clear, smooth, transparent coating.

AC plasma display panels of this invention are based on substrates having fired metallizations thereon and coated with an overglaze. The fired metallizations are based on the above silver composition. The overglaze is provided by the process of this invention described above. Two such overglazed substrates are sealed together face-to-face, the space between the two portions is evacuated and then filled with inert gas.

## Description of the Invention

The thick film composition used in this invention contains 50—85% by weight of finely divided silver particles. These particles can range in size from 0.05—20 micrometers (micron) and can be random or flake in shape.

For compositions which have UV polymerizable vehicles, the silver particle size range is 0.3—10 micron (majority 1—5$\mu$) and the particles are random in shape. Compositions which have non-UV polymerizable vehicles can tolerate the very fine particles which could otherwise function as a UV screen.

A preferred composition contains 66% silver particles by weight of the fully formulated thick film paste; the particles having a surface area of 0.34 m$^2$/g, as measured by a gas adsorption method and a size range of 0.3—10 microns (majority in the approximately 1—5 micron range), as measured by scanning electron microscopy.

The conductor composition further contains 1—10% by weight of finely divided inorganic particlate non-glass forming materials which are refractory or their precursors. These materials include aluminum oxide, cadmium oxide, gadolinium oxide, zirconium oxide cobalt/iron/chromium oxide and aluminum. These oxides or oxide precursors have a particle size range of 0.05—44 micrometers, with at least 80% by weight of the particles in the 0.1—5 micrometer range, and are an essential component of the conductor compositions.

The presence of these refractory materials in the compositions used in this invention unexpectedly allowed the utilization of silver-based metallizations in AC plasma display panels by increasing the resistance of the fired metallizations to fissuring during the overglazing process.

Although the mechanism of such anti-fissuring action is not known for sure, it is thought that these anti-fissuring agents coat or surround the metal particles thereby retarding their sintering together and inhibiting their withdrawal from the glass phase, a phenomenon which would result in fissuring.

A preferred anti-fissuring agent is alumina, present to an extent of 2.6% by weight of a fully formulated preferred composition. In this composition the alumina has a surface area of 10.6 $m^2$/g and a particle size of 0.65 $\mu$m at the 50% point in a sedimentation test.

The anti-fissuring composition of this invention also contains 5—20% by weight of glass frit having a softening point range of 325—600°C.

Preferred glass frits include the lead borosilicate-type glasses; an especially preferred composition is (mole %): PbO (53.1), $B_2O_3$ (2.9), $SiO_2$ (29.0), $TiO_3$ (3.0), $ZrO_2$ (3.0), ZnO (2.0), $Na_2O$ (3.0), and CdO (4.0).

The glasses can be prepared by conventional glass-making techniques, by mixing the desired components (or precursors thereof, e.g., $H_3BO_3$ for $B_2O_3$) in the desired proportions and heating the mixture to form a melt. As is well known in the art, heating is conducted to a peak temperature and for a time such that the melt becomes entirely liquid, yet gaseous evolution has ceased. In this work, the peak temperature is in the range 1100—1500°C, usually 1200—1400°C. The melt is then fritted (particles are made) by cooling the melt, typically by pouring onto a cold belt or into cold running water. Particle size reduction can then be accomplished by milling as desired.

The above mentioned lead borosilicate glass is prepared by melting the appropriate ingredients at 1350°C followed by fritting and ball milling and has a softening point of 580—590°C.

The composition used in this invention further contains 10—30% by weight of a vehicle in which the particulate materials are dispersed. Depending on the method of application of the compositions and the method of obtaining the fine line metallizations, the vehicle can be UV polymerizable or non-UV polymerizable.

An example of a UV polymerizable vehicle is a solution of polymethyl methacrylate and a polyfunctional monomer. The monomer should have low volatility in order to minimize its evaporation during the preparation of the paste and the printing/drying steps prior to UV curing.

The vehicle can also contain solvents and, in the case of the UV curable vehicles, UV sensitive initiators.

A preferred UV polymerizable vehicle contains a polymer based on methyl methacrylate/ethyl acrylate//95/5 (by weight), having an inherent viscosity as determined as a solution of 0.25 gram of polymer in 50 milliliters of chloroform, at 25°C using a No. 50 Cannon-Fenske Viscometer, of 0.45, and polyoxyethylated trimethylpropane triacrylate having a total of approximately 20 units of incorporated ethylene oxide.

A preferred non-UV polymerizable vehicle is based on ethyl cellulose.

Suitable solvents for the vehicles include butyl carbitol acetate and beta-terpineol.

Additionally, the vehicles can also contain dispersing agents, stabilizers, etc.

The compositions can be applied to glass substrates in a conventional manner, a preferred mode being screen printing. In case of silver compositions based on UV polymerizable vehicles, the composition can be screen printed, dried, exposed to UV radiation through a patterned photomask, and treated with solvent to remove unexposed areas. The patterned glass substrate is then fired resulting in a well defined fine line pattern having excellent density and high conductivity.

The glass substrate can be sheet or pulled glass and, also, float glass. Preferably, soda lime sheet glass is utilized. When float glass is utilized, a surface etching step is performed.

The fired metallizations are used in the process of the invention for obtaining clear, smooth, and transparent dielectric overglaze over the patterned (and fired) glass substrates. The silver conductor lines remain well adhered to the substrate showing no breaks or fissure upon the completion of this process.

The overglaze composition preferably utilized in the process of this invention contains a glass frit of the composition (mole %): PbO (68.2), $SiO_2$ (12.0), $B_2O_3$ (14.1), and CdO (5.7), having a softening point of approximately 480°C. The overglaze composition, dispersed in an ethyl cellulose-based vehicle, is screen printed over the fired conductor, dried, and then fired at a temperature and for a time sufficient to produce a clear, smooth coating.

The AC plasma display panels of this invention are based on glass substrates having patterned and fired metallizations coated by a dielectric overglaze.

The fired metallizations are based on the thick film conductor compositions described above. The process of coating with an overglaze is described above.

A sequence of steps in preparing AC plasma display panels is as follows:

The thick film electrodes are optically inspected for electrode breaks, shorts and other defects. To the extent possible, the defects are repaired. Thick film pads are screen printed over the thick film silver on the two opposite ends of each substrate in the connector pad area. These screen printed pads can be 90 micrometers or less wide. Alternate electrodes are brought out opposite sides of the panel is an inter-lace fashion.

A vitreous lead borosilicate glass as described above can be used for the dielectric overglaze. The glass frit mixed with suitable vehicles and formed into a paste is screen printed over the entire display area of each substrate. Glass rod spacers are placed in the wet dielectric at appropriate positions between electrodes on each back substrate. The dielectric is cured in a uniform temperature, belt driven oven.

Since the dielectric cure temperature is above the strain point of the glass substrate, precautions must be taken to avoid substrate warping. The substrates are placed on flat support plates and the oven belt speed and temperature zones are adjusted so that the substrates are heated and cooled very slowly. Following curing, the dielectrics are visually inspected, electrodes continuity and resistance are measured electrically and dielectric thickness and substrate flatness are measured on a random sampling basis.

The conductor lines are uniform in line width and are not pitted or broken, have high conductivity, optical clarity and transparency between lines.

A devitrifying solder glass is used for sealing together the two printed and overglazed substances. After screen printing the seal, the parts are placed in an oven and fired at a low temperature to burn out the sealing glass binders and harden the seal. A thin film coating is then deposited over the entire glass dielectric.

One back and one front substrate are then aligned orthogonally and clamped together. A small amount of solder glass paste is placed on the end of an appendage tube which is then positioned in a hole in the back substrate. The assembly is then placed in an oven and the parts are sealed together.

The appendage of each assembly is sealed onto the manifold of a gas process station. The panels are evacuated, baked out and back-filled with a gas mixture of, e.g., neon and xenon. The panels are then tipped-off the vacuum station.

Each panel is aged until stabilized. These panels can be tested, attached to connector cables, and inserted in display units.

The silver compositions used in this invention can also be utilized to fabricate multilayer elements.

In the Example below, illustrating the invention, all parts are by weight unless otherwise indicated.

### Example

A. A silver conductor composition is prepared from the following ingredients:

|  | parts |
|---|---|
| silver powder (surface area: 0.34 m²/g; particle size: 0.3—10μm, with majority in 1—5μm range) | 66.0 |
| alumina powder (surface area: 10.6 m²/g; particle size: 0.65μm at 50% sedimentation) | 2.6 |
| lead borosilicate frit (composition, mole%, PbO, 53.1; B₂O₃, 2.9; SiO₂, 29.0; TiO₂, 3.0; ZrO₂, 3.0; ZnO, 2.0; Na₂O, 3.0; CdO, 4.0; prepared from, parts, PbO, 49.4; H₃BO₃, 4.9; SiO₂, 27.0; TiO₂, 2.8; ZrO₂, 2.8; ZnO, 1.9; NaHCO₃, 7.5; CdO, 3.7; by melting at 1350°C, followed by fritting and ball milling for 16 hours) | 7.9 |
| poly(methyl methacrylate/ethyl acrylate//95/5, by weight), as described above, dissolved in butyl carbitol acetate, 32/65, by weight | 17.6 |
| polyoxyethylated trimethylpropane triacrylate, as described above | 2.6 |
| butyl carbitol acetate | 2.4 |
| tert-butylanthraquinone (TBAQ) | 0.5 |
| soya lecithin wetting agent | 0.2 |
| stabilizer | 0.2 |

This composition is prepared as follows:

(a) a solution of 32 parts of the above polymer and 3 parts TBAQ in 65 parts of butyl carbitol acetate is prepared;

(b) an intimate mixture of finely divided alumina and the lead borosilicate frit is prepared by vibratory milling together a mixture of 3 parts of alumina powder and 9 parts of the glass frit in isopropanol for 6 hours. The resulting mixture is dried at 100°C. (Vibratory milling is carried out in an organic medium by placing inorganic powders and alumina cylinders into a container which is then vibrated for a specified length of time.)

(c) on a three-roll mill the following mixture is thoroughly mixed: 75 parts of silver powder, 12 parts of alumina/frit mixture from (b) above, 20 parts of vehicle (a) above, 0.2 parts of wetting agent and 0.2 parts of stabilizer;

(d) to the composition produced above is added 3 parts of the above monomer, which is stirred in;

(e) the composition is adjusted to a final viscosity of 55 Pascal seconds by the addition of 3.3 parts of butyl carbitol acetate.

Fired metallizations are prepared as follows:

The composition is screen printed onto soda lime glass with a 200 mesh stainless steel screen and dried at 100°C for 30 minutes in a circulating air oven. The dried coating is exposed to UV radiation through a photomask patterned with 3-mil wide lines for 2 minutes. A 1000-watt xenon-mercury lamp is utilized. Nitrogen gas is flowed through the exposure chamber during exposure. After exposure the dried coating is sprayed with 1,1,1-trichloroethane solvent, producing a pattern of well defined 3-mil wide lines. The patterned glass substrate is fired in air by passing through a belt furnace (2 hour cycle, peak temperature, for approximately 15 minutes, 600°C). The resulting silver conductor lines have excellent fired film density and a resistivity of 8.2 milliohms/square.

B. The fired metallizations from (A) above are coated with an overglaze composition containing 85 parts of a class frit (composition, mole%: PbO, 68.2; $SiO_2$, 12.0; $B_2O_3$, 14.1; CdO, 5.7; softening point of 480°C) and 14 parts of an ethyl cellulose vehicle. This overglaze composition is applied with a 150 mesh stainless steel screen, dried at 100°C and fired in a box furnace, holding at a peak temperature of 640°C for 1 hour. The resulting overglaze is clear, smooth and transparent. The silver conductor lines remain well adhered to the glass substrate, with no breaks or fissures. The resistivity of the lines is 5.8 milliohms/square. The overglazed substrate so obtained is useful in preparing AC plasma display panels.

## Claims

1. A process for providing overglaze for fired metallizations comprising the steps of:

(A) printing, drying and curing onto a substrate a thick film conductor composition consisting essentially of:

(1) 50—85% by weight, based on the weight of the composition, of silver particles having a particle size range of 0.05—20 micrometers;

(2) 1—10% by weight, based on the weight of the composition, of inorganic non-glass forming refractory materials or their precursors selected from the group consisting of aluminum oxide, cadmium oxide, gadolinium oxide, zirconium oxide, cobalt/iron/chromium oxide, and aluminum, having a particle size range of 0.05—44 micrometers with at least 80% by weight of the particles in the 0.1—5 micrometer range;

(3) 5—20% by weight, based on the weight of the composition, of glass frit having a softening point range of 325—600°C; and

(4) 10—30% by weight, based on the weight of the composition, of vehicle;

(B) firing the product of step (A); and

(C) applying an overglaze composition over the fired product of step (B) and firing at a temperature and for a time sufficient to produce a clear, smooth, transparent coating.

2. The process of Claim 1 wherein the vehicle utilized in step (A) is a UV polymerizable vehicle.

3. The process of Claim 1 or 2 wherein the refractory material utilized in step (A) is aluminum oxide.

4. An AC plasma display panel comprising two overglazed substrates produced by the process of Claim 1, sealed together face-to-face, wherein the space between said two substrates is filled with inert gas.

## Revendications

1. Procédé pour former un revêtement d'émail sur des métallisations cuites, caractérisé en ce qu'il comprend les étapes selon lesquelles:

(A) On applique par impression, on sèche et on durcit sur un support une composition pour conducteurs en film épais constituée essentiellement de:

(1) 50—85% en poids, par rapport au poids de la composition, de particules d'argent ayant une gamme de grosseur de particules de 0,05 à 20 micromètres;

(2) 1—10% en poids, par rapport au poids de la composition, de matières réfractaires inorganiques non vitrifiables ou leurs progéniteurs choisies parmi l'oxyde d'aluminium, l'oxyde de cadmium, l'oxyde de gadolinium, l'oxyde de zirconium, l'oxyde de cobalt/fer/chrome et l'aluminium, ayant une gamme de grosseurs de particules de 0,05—44 micromètres avec au moins 80% en poids des particules dans l'intervalle 0,1—5 micromètres;

(3) 5—20% en poids, par rapport au poids de la composition, de fritte de verre ayant un intervalle de point de ramollissement de 325—600°C; et

(4) 10—30% en poids, par rapport au poids de la composition, d'un véhicule;

(B) on ciut le produit de l'étape (A); et

(C) on applique une composition d'émail sur le produit cuit de l'étape (B) et on la cuit à une température et pendant un temps suffisants pour produire un revêtement clair, lisse, transparent.

2. Procédé selon la revendication 1, caractérisé en ce que le véhicule utilisé dans l'étape (A) est un véhicule polymérisable par UV.

3. Procédé selon l'une des revendications 1 et 2, caractérisé en ce que la matière utilisée dans l'étape (A) est de l'oxyde d'aluminium.

4. Panneau d'affichage à plasma AC, caractérisé en ce qu'il comprend deux supports émaillés produits par le procédé selon la revendication 1, soudés ensemble face à face, l'espace entre les supports étant rempli d'un gaz inerte.

## Patentansprüche

1. Verfahren zur Herstellung einer Aufglasur für gebrannte Metallisierungen, umfassend die Schritte:

(A) Drucken, Trocknen und Härten auf einem Substrat eine Dickfilm-Leiterzusammensetzung, bestehend im wesentlichen aus:

(1) 50 bis 85 Gew.-%, bezogen auf das Gewicht der Zusammensetzung, Silberteilchen mit einem Teilchengrößenbereich von 0,05 bis 20 Micrometer;

(2) 1 bis 10 Gew.-%, bezogen auf das Gewicht der Zusammensetzung, anorganische nicht-glasbildende feuerfeste Materialien oder deren Vorläufer, ausgewählt aus der Gruppe bestehend aus Aluminiumoxid, Cadmiumoxid, Gadoliniumoxid, Zirkoniumoxid, Kobalt-/Eisen-/Chromoxid und Aluminium mit einem Teilchengrößenbereich von 0,05 bis 44 Micrometer, wobei wenigstens 80 Gew.-% der Teilchen in dem 0,1 bis 5 Micrometerbereich liegen;

(3) 5 bis 20 Gew.-%, bezogen auf das Gewicht der Zusammensetzung, einer Glasfritte mit einem Erweichungspunktbereich von 325 bis 600°C; und

(4) 10 bis 30 Gew.-%, bezogen auf das Gewicht der Zusammensetzung, eines Trägers;

(B) Brennen des Produktes von Stufe (A); und

(C) Auftragen einer Aufglasurzusammensetzung auf das gebrannte Produkte von Stufe (B) und Brennen bei einer Temperatur und während einer Zeit, die ausreichend sind, um einen klaren, glatten, transparenten Überzug zu erzeugen.

2. Verfahren nach Anspruch 1, in welchem der in Stufe (A) verwendete Träger ein UV-polymerisierbarer Träger ist.

3. Verfahren nach Anspruch 1 oder 2, in welchem das in Stufe (A) verwendete feuerfeste Material Aluminiumoxid ist.

4. AC-Plasma-Anzeigeplatte, umfassend zwei, nach dem Verfahren von Anspruch 1 hergestellte, mit einer Aufglasur versehene Substrate, die Vorderseite-an-Vorderseite dicht miteinander verbunden sind, in welcher der Raum zwischen den genannten beiden Substraten mit Inertgas gefüllt ist.